# EUROPÄISCHE PATENTSCHRIFT

(11) **EP 2 034 533 B1**
(45) Veröffentlichungstag und Bekanntmachung des Hinweises auf die Patenterteilung: **21.04.2010**
(21) Anmeldenummer: 08105111.2
(22) Anmeldetag: 25.08.2008
(51) Int. Cl.: H01L 41/083, H01L 41/047

(54) **Piezoaktormodul mit mehreren untereinander verbundenen Piezoaktoren**
Piezo actuator module with several piezo actuators connected in series
Module de piézoactionneur comprenant plusieurs piézoactionneurs connectés en série

(30) Priorität: 05.09.2007 DE 102007042224
(43) Veröffentlichungstag der Anmeldung: 11.03.2009
(73) Patentinhaber: Robert Bosch GmbH, 70442 Stuttgart (DE)
(72) Erfinder: Klotz, Claudia, 96047, Bamberg (DE); Stroehlein, Joerg, 96199, Zapfendorf (DE); Schlegl, Nicole, 73635, Rudersberg (DE); Pohl, Gerd, 02906, Waldhufen Thiemendorf (DE); Martin, Ottmar, 96175, Pettstadt (DE); Schrader, Daniel, 71665, Vaihingen/Enz (DE)

(56) Entgegenhaltungen:
- EP-A- 1 503 435
- EP-A- 1 705 722
- WO-A-2007/141134
- DE-A1-102005 035 158
- US-A- 5 438 232

## Beschreibung

### Stand der Technik

Die Erfindung betrifft ein Piezoaktormodul mit einer Anordnung von mehreren mechanisch in Reihe geschalteten Piezoaktoren, vorzugsweise zur Verwendung in einem Piezoinjektor, nach den gattungsgemäßen Merkmalen des Hauptanspruchs.

Ein solcher Piezoinjektor besteht im wesentlichen aus einem Haltekörper und dem in dem Haltekörper angeordneten Piezoaktormodul, das die zwischen einem Kopf- und Fußteil und Anbindebauteilen angeordneten Piezoaktoren aufweist, die jeweils aus mehreren übereinandergestapelten Piezoelementen aufgebaut sind.

Es ist an sich bekannt, dass zum Aufbau des zuvor erwähnten Piezoaktors Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor sind ebenfalls Piezoelemente als Stapel angeordnet, der über einen Aktorfuß und einen Aktorkopf unter Vorspannung zwischen zwei Anschlägen gehalten ist Jede Piezolage ist auch hier zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei diesen bekannten CR-Injektoren ist in der Regel eine indirekt vom Piezoaktormodul gesteuerte Düsennadel als Kraftstoffventil vorhanden, wobei die Piezoaktoren eine Realisierung der Öffnungs-und Schließfunktion ermöglicht. Für eine Anwendung dieser Piezoinjektoren mit direkter Nadelsteuerung in einem Kraftstoffdruck bis zu 2000 bar reicht jedoch der Hub eines einzelnen Piezoaktors nicht zu der direkten Steuerung aus. Der notwendige Mindesthub kann nun dadurch realisiert werden, dass mindestens zwei Piezoaktoren stirnseitig zu einer Aktorreihe aneinandergefügt werden.

Es ist dabei hinlänglich bekannt, dass diese Reihe aus mehreren einzelnen Piezoaktoren beispielsweise zusammengeklebt ist und gekapselt in einer metallischen Hülse das Herzstück des zuvor erläuterten Piezoinjektors bildet. Die elektrische Verbindung der einzelnen Piezoaktoren bzw. deren Außenelektroden zur Kontaktierung der Innenelektroden kann dabei in an sich bekannter Weise beispielsweise mittels einer elektrisch leitenden Brücke zwischen den Außenelektroden gleicher Polarität der einzelnen Piezoaktoren realisiert werden. Ein entsprechendes Piezoaktormodul ist beispielsweise aus der US 5,438,232 A bekannt.

Durch die zuvor erwähnte leitende Brücke, in der Regel eine ein- oder mehrfach gefaltete Siebbrücke, und deren Fügeverfahren auf den Außenelektroden ergeben sich Nachteile wahrend des Aufbaus des Piezoaktormoduls. Bei einem Fügeverfahren mit einem Schweißvorgang muss dieser dabei teilweise in dem Bereich der aktiven Piezolagen auf den Außenelektroden der Piezoaktoren durchgeführt werden, wobei der Wärmeeintrag durch den Schweißprozess ein hohes Schädigungsrisiko birgt. Eventuell entstehende Schmauchspuren im Bereich der Schweißstellen stellen ein Risiko für die nachfolgende Beschichtungsschritte dar.

### Offenbarung der Erfindung

Die Erfindung geht von einem Piezoaktormodul mit mindestens zwei in der mechanischen Wirkungsrichtung hintereinander geschalteten Piezoaktoren aus, die jeweils aus in der mechanischen Wirkungsrichtung hintereinander geschalteten Piezoelementen mit über Außenelektroden kontaktierten Innenelektroden wechselnder Polarität bestehen. Gemäß der Erfindung ist eine leitende Brücke zwischen den Außenelektroden jeweils gleicher Polarität vorhanden, wobei die leitenden Brücken zwischen den Außenelektroden jeweils gleicher Polarität über ein elektrisch isolierendes Verbindungselement zur Herstellung eines elektrischen Kontakts zu den jeweiligen Außenelektroden mechanisch an diese Außenelektroden angedrückt sind.

Nach einer ersten vorteilhaften Ausführungsform der Erfindung ist das Verbindungselement ein die Verbindungsstellen der Piezoaktoren und damit die sich gegenüberliegenden Brücken gemeinsam umfassendes Federelement, dass auf die Brücken durch seine Federwirkung eine mechanische Vorspannung ausübt, die zum elektrischen Kontakt der Brücke mit den Außenelektroden führt. Vorzugsweise weist das Federelement als Federring einen runden oder ovalen Querschnitt und eine ringförmige, geschlossene oder eine offene U-Ausführung auf und ist aus einem elektrisch isoliertem Metall oder einem Polymer, vorzugsweise einem Vitonring, oder aus einer Kombination dieser Materialien aufgebaut.

Gemäß einer zweiten Ausführungsform der Erfindung ist das Verbindungselement jeweils ein mit der jeweiligen Brücke verbundenes Klemm- oder Klammerelement, das in oder um die jeweilige Brücke an der Verbindungsstelle der Piezoaktoren klemm- oder klammerbar ist und durch seine Klemm- oder Klammerwirkung eine mechanische Vorspannung ausübt, die zum elektrischen Kontakt der Brücke mit den Außenelektroden führt.

Die erfindungsgemäßen Verbindungselemente sind insofern vorteilhaft, da sie ein eventuell die Keramik der Piezoaktoren schädigendes Fügeverfahren für die Anbringung der Brücken, wie zum Beispiel ein Schweißverfahren, überflüssig machen und den notwendigen elektrischen Kontakt zwischen den Außenelektroden gleicher Polarität der reihengeschalteten Piezoaktoren über die leitenden Brücken allein durch eine auf die Brücken wirkende mechanische Vorspannung durch einen Feder-, Klemm- oder Klammereffekt bewirken.

### Kurze Beschreibung der Zeichnungen

Ausführungsbeispiele des erfindungsgemäßen Piezoaktormoduls werden anhand der Zeichnung erläutert. Es zeigen:
- Figur 1: eine Ansicht auf zwei aneinandergereihte Piezoaktoren für ein Piezoaktormodul mit einem als Federring ausgeführten Verbindungselement über leitende Brücken zwischen den Piezoaktoren,
- Figur 2: einen Schnitt durch die Anordnung nach der Figur 1,
- Figur 3: einen Detailschnitt durch den Bereich der Verbindungsstelle der Piezoaktoren nach den Figuren 1 und 2,
- Figur 4: eine Ansicht auf zwei aneinandergereihte Piezoaktoren für ein Piezoaktormodul mit als Klammern ausgeführten Verbindungselementen über leitende Brücken zwischen den Piezoaktoren,
- Figur 5: einen Schnitt durch die Anordnung nach der Figur 4 und
- Figur 6: einen Detailschnitt durch den Bereich der Verbindungsstelle der Piezoaktoren nach den Figuren 4 und 5.

### Ausführungsformen der Erfindung

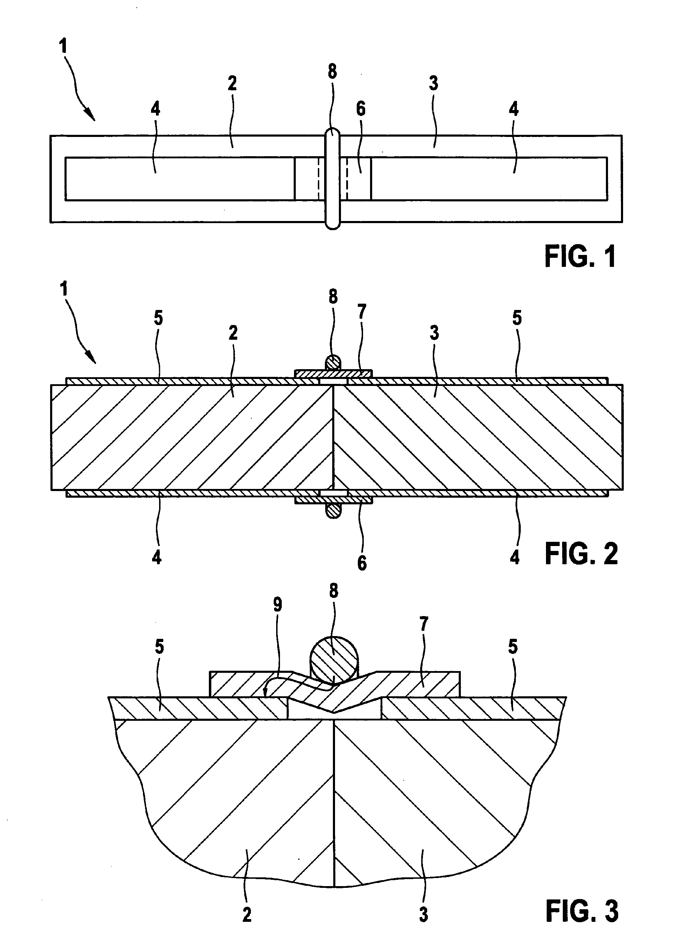

Im Folgenden wird ein Piezoaktormodul 1 erläutert, das beispielsweise für einen Piezoinjektor zur Nadelhubsteuerung in einem Einspritzsystem für Kraftstoff bei einem Verbrennungsmotor eingesetzt werden kann, wie es eingangs anhand des Standes der Technik beschrieben ist. Hierzu sind nach Figur 1 und Figur 2 ein Piezoaktor 2 und ein Piezoaktor 3 zur Bildung des Piezoaktormoduls 1 in der mechanischen Wirkrichtung hintereinander geschaltet, so dass mit den in der Beschreibungseinleitung beschriebenen Piezoelementen in den Piezoaktoren 2 und 3 ein mechanischer Hub in der Längserstreckung des Piezoaktormoduls 1 bewirkt werden kann.

Die Piezoelemente in den Piezoaktoren 2 und 3 werden durch Innenelektroden der einen Polarität und Innenelektroden der jeweils anderen Polarität und den dazwischenliegenden Piezolagen gebildet. Die Piezoaktoren 2 und 3 des Piezoaktormoduls 1 weisen dabei jeweils Außenelektroden 4 und 5, beispielsweise Siebelektroden, auf. Die Außenelektroden 4 und 5 kontaktieren hier jeweils die Innenelektroden in den Piezoaktoren 2 und 3 und können zum Beispiel mittels einer Dampfphasenlötung schon vor dem Zusammenfügen der Piezoaktoren 2 und 3 elektrisch leitend aufgebracht werden. Zur Verbindung der Außenelektroden 4 oder 5 auf den Piezoaktoren 2 und 3 in der jeweils gleichen Polarität sind leitende Brücken 6 und 7, zum Beispiel Siebbrücken, vorhanden, die mit den jeweiligen Außenelektroden 4 oder 5 auf beiden Piezoaktoren 2 und 3 zu kontaktieren sind.

Zur Herstellung dieses elektrischen Kontakts ist beim Ausführungsbeispiel nach den Figuren 1 und 2 sowie nach der Detaildarstellung in Figur 3 ein isoliertes oder isolierendes Federelement 8, hier ein runder Federring, zum Beispiel ein Vitonring, vorhanden. Hier ist beispielhaft anhand des Pfeiles 9 gezeigt, wie die Vorspannung des Federelements 8 zu einer Kraftausübung auf die Brücke 7 zur Herstellung des elektrischen Kontakts mit der Außenelektrode 5 des Piezoaktors 2 führt. Die Kraftausübung auf die Brücke 7 zur Herstellung des elektrischen Kontakts mit der Außenelektrode 5 des Piezoaktors 3 verläuft analog. Bei einer hier nicht gezeigten Variante ist auch ein offener, zum Beispiel eckig gebogener Federring anwendbar, der seitlich auf die Brücke 7 geschoben wird.

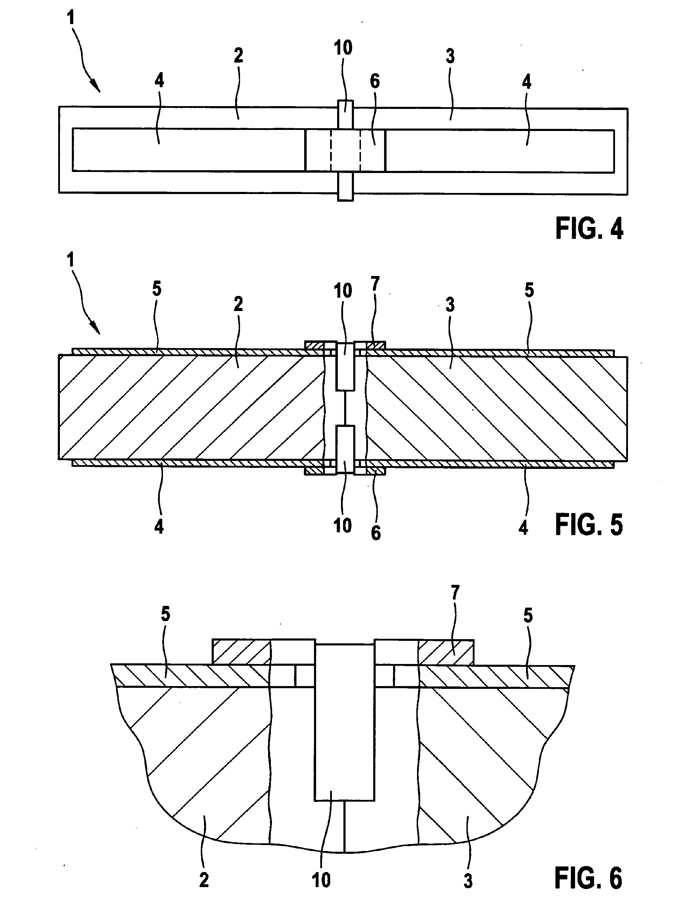

Auch beim Ausführungsbeispiel nach Figur 4 in der Ansicht und Figur 5 im Schnitt werden zur Verbindung der Außenelektroden 4 oder 5 in der jeweils gleichen Polarität leitende Brücken 6 und 7, zum Beispiel Siebbrücken, vorgesehen, die mit den jeweiligen Außenelektroden 4 oder 5 auf beiden Piezoaktoren 2 und 3 zu kontaktieren sind.

Zur Herstellung dieses elektrischen Kontakts ist bei diesem Ausführungsbeispiel nach den Figuren 4 und 5 sowie nach der Detaildarstellung in Figur 6 jeweils eine Klammer 10 an jeder Brücke 6 und 7 vorhanden, die außen an der Verbindungsstelle der Piezoaktoren 2 und 3 angreift und die Brücken 6 oder 7 auf die Außenelektroden 4 oder 5 drückt. Die Klammerwirkung führt auch hier zu einer Vorspannung und damit zu einer Kraftausübung auf die Brücke 6 oder 7 zur Herstellung des elektrischen Kontakts mit der Außenelektrode 4 oder 5 der Piezoaktoren 2 und 3.

## Patentansprüche

1. Piezoaktormodul mit mindestens zwei in der mechanischen Wirkungsrichtung hintereinander geschalteten Piezoaktoren (2,3), die jeweils aus in der mechanischen Wirkungsrichtung hintereinander geschalteten Piezoelementen mit über Außenelektroden (4,5) kontaktierten Innenelektroden wechselnder Polarität bestehen, und mit einer leitenden Brücke (6,7) zwischen den Außenelektroden (4,5) jeweils gleicher Polarität der Piezoaktoren (2,3), **dadurch gekennzeichnet, dass** die leitenden Brücken (6,7) zwischen den Außenelektroden (4,5) jeweils gleicher Polarität über ein elektrisch isolierendes Verbindungselement (8;10) zur Herstellung eines elektrischen Kontakts zu den jeweiligen Außenelektroden (4,5) an die Außenelektroden (4,5) angedrückt sind.

2. Piezoaktormodul nach Anspruch 1, **dadurch gekennzeichnet, dass** das Verbindungselement ein die Verbindungsstellen der Piezoaktoren (2,3) und damit die sich gegenüberliegenden Brücken (6,7) gemeinsam umfassendes Federelement (8) ist, dass auf die Brücken (6,7) durch seine Federwirkung eine mechanische Vorspannung ausübt, die zum elektrischen Kontakt der jeweiligen Brücke (6,7) mit den Außenelektroden (4,5) führt.

3. Piezoaktormodul nach Anspruch 2, **dadurch gekennzeichnet, dass** das Federelement (8) als Federring einen runden oder ovalen Querschnitt und eine ringförmige, geschlossene oder eine offene U-Ausführung aufweist.

4. Piezoaktormodul nach einem der vorhergehenden Ansprüche, **dadurch gekennzeichnet, dass** das Federelement (8) aus einem elektrisch isoliertem Metall oder einem Polymer, vorzugsweise einem Vitonring, oder aus einer Kombination dieser Materialien besteht.

5. Piezoaktormodul nach Anspruch 1, **dadurch gekennzeichnet, dass** das Verbindungselement jeweils ein auf die jeweilige Brücke (6,7) aufsteckbares Klemm- oder Klammerelement (10) ist, das in oder um die jeweilige Verbindungsstelle der Piezoaktoren (2,3) klemm- oder klammerbar ist und durch seine Klemm- oder Klammerwirkung eine mechanische Vorspannung ausübt, die zum elektrischen Kontakt der Brücke (6,7) mit den Außenelektroden (4,5) führt.

## Claims

1. Piezo-actuator module having at least two piezo-actuators (2, 3) which are connected one behind the other in the mechanical operating direction and each comprise piezo-elements, which are connected one behind the other in the mechanical operating direction and have internal electrodes, with which contact is made via external electrodes (4, 5), of alternating polarity, and having a conductive link (6, 7) between the respective external electrodes (4, 5) of the same polarity of the piezo-actuators (2, 3), **characterized in that** the conductive links (6, 7) between the respective external electrodes (4, 5) of the same polarity are pressed onto the external electrodes (4, 5) via an electrically insulating connecting element (8, 10), in order to make an electrical contact with the respective external electrodes (4, 5).

2. Piezo-actuator module according to Claim 1, **characterized in that** the connecting element is a spring element (8) which jointly surrounds the connecting points of the piezo-actuators (2, 3) and therefore the mutually opposite links (6, 7), **in that** mechanical prestressing is exerted on the links (6, 7) by the spring effect of the spring element (8), and leads to electrical contact between the respective link (6, 7) and the external electrodes (4, 5).

3. Piezo-actuator module according to Claim 2, **characterized in that** the spring element (8), as a spring washer, has a round or oval cross section and an annular, closed shape or an open U-shape.

4. Piezo-actuator module according to one of the preceding claims, **characterized in that** the spring element (8) is composed of an electrically insulating metal or a polymer, preferably a Viton ring, or a combination of these materials.

5. Piezo-actuator module according to Claim 1, **characterized in that** the connecting element is in each case a clamping or bracket element (10) which can be plugged onto the respective link (6, 7), can be clamped or bracketed in or around the respective connecting point of the piezo-actuators (2, 3) and, by its clamping or bracketing effect, exerts mechanical prestressing, which leads to the electrical contact between the link (6, 7) and the external electrodes (4, 5).

## Revendications

1. Module de piézoactionneur qui présente
au moins deux piézoactionneurs (2, 3) raccordés l'un à la suite de l'autre dans la direction d'action mécanique et constitués chacun de piézoéléments raccordés les uns derrière les autres dans la direction d'action mécanique et présentant des électrodes intérieures de polarité alternée mises en contact par l'intermédiaire d'électrodes extérieures (4, 5) et
un pont conducteur (6, 7) entre les électrodes extérieures (45) de même polarité des piézoactionneurs (2, 3),
**caractérisé en ce que**
les ponts conducteurs (6, 7) situés entre les électrodes extérieures (4, 5) de même polarité sont repoussés contre les électrodes extérieures (4, 5) par l'intermédiaire d'un élément de liaison (8; 10) électriquement isolant en vue d'établir un contact électrique avec chacune des électrodes extérieures (4, 5).

2. Module de piézoactionneur selon la revendication 1, **caractérisé en ce que** l'élément de liaison est un élément élastique (8) qui comprend conjointement les emplacements de liaison des piézoactionneurs (2, 3) et donc les ponts (6, 7) mutuellement opposés et dont l'effet élastique applique sur les ponts (6, 7) une précontrainte mécanique qui entraîne un contact électrique entre chacun des ponts (6, 7) et l'électrode extérieure (4, 5) respective.

3. Module de piézoactionneur selon la revendication 2, **caractérisé en ce que** l'élément élastique (8) est configuré comme anneau élastique annulaire, fermé ou en U ouvert, à section transversale ronde ou ovale.

4. Module de piézoactionneur selon l'une des revendications précédentes, **caractérisé en ce que** l'élément élastique (8) est constitué d'un métal ou polymère électriquement isolants, de préférence d'un anneau en Viton, ou d'une combinaison de ces matériaux.

5. Module de piézoactionneur selon la revendication 1, **caractérisé en ce que** l'élément de liaison est un élément de pinçage ou d'agrafage (10) qui peut être enfiché sur chaque pont (6, 7), qui peut être pincé ou agrafé dans ou autour de l'emplacement de liaison correspondant des piézoactionneurs (2, 3) et dont l'effet de pinçage ou d'agrafage exerce une précontrainte mécanique qui conduit à l'établissement du contact électrique entre le pont (6, 7) et les électrodes extérieures (4, 5).
